# EUROPEAN PATENT APPLICATION

(11) **EP 4 439 680 A1**
(43) Date of publication of application: **02.10.2024**
(21) Application number: 23165860.0
(22) Date of filing: 31.03.2023
(51) Int. Cl.: H01L 29/861, H01L 29/744, H01L 29/06, H01L 29/08, H01L 21/329, H01L 21/332, H01L 29/417

(54) **POWER SEMICONDUCTOR DEVICE AND METHOD FOR PRODUCING A POWER SEMICONDUCTOR DEVICE**

(71) Applicant: Hitachi Energy Ltd, 8050 Zürich (CH)
(72) Inventor: VEMULAPATI, Umamaheswara, 5210 Windisch (CH); VOBECKY, Jan, 16000 Praha 6 (CZ); WIKSTROEM, Tobias, 5704 Egliswil (CH); STIASNY, Thomas, 8820 Wädenswil (CH)
(74) Representative: Epping - Hermann - Fischer

(57) **Abstract**

A power semiconductor device (1) is specified, comprising
- a first electrode (2),
- a first semiconductor layer (3) of a first conductivity type,
- a drift layer (4) of the first conductivity type,
- a second semiconductor layer (5) of a second conductivity type different from the first conductivity type, and
- a second electrode (6), wherein
- at least one of the first semiconductor layer (3) and the second semiconductor layer (5) comprises an oxide layer (24) extending in an active region (9) of the power semiconductor device (1) being surrounded by a termination region (8) of the power semiconductor device (1), and
- at least one of the first semiconductor layer (3) and the second semiconductor layer (5) has a bevel structure (19).

Furthermore, a method for producing a power semiconductor device (1) is specified.

## Description

The present disclosure relates to a power semiconductor device and to a method for producing a Power semiconductor device.

Embodiments of the disclosure relate to a power semiconductor device, which has an improved performance. Further embodiments of the disclosure relate to a method for producing such a power semiconductor device.

This is achieved by the subject-matter of the independent claims. Further embodiments are evident from the dependent claims in the following description.

A power semiconductor device is described. The term "power" here and in the following, for example, refers to power semiconductor modules, power semiconductor devices and/or power semiconductor chips adapted for processing voltages and currents of more than 100 V and/or more than 10 A, exemplary voltages up to 10 kV and currents of amperes up to 10 kA.

According to an embodiment, the power semiconductor device comprises a first electrode. The first electrode extends exemplarily in lateral directions. For example, the first electrode is configured to be electrically conductively contacted externally. Exemplarily, the first electrode comprises or consists of a metal.

The first electrode can comprise a first layer and a second layer, being stacked above one another in vertical direction, which is perpendicular to the lateral directions. For example, the first layer comprises a metal which is different from a metal comprised by the second layer. The first layer comprises exemplarily molybdenum and the second layer comprises exemplarily aluminum and/or other metals like copper, titanium and/or nickel. In particular, the first layer is configured to be electrically conductively contacted externally and the second layer is a metallization. For example, the metallization is applied in a method using a sputtering process or an evaporation process.

According to the embodiment, the power semiconductor device comprises a first semiconductor layer of a first conductivity type. The first semiconductor layer extends exemplarily in lateral directions. For example, the first semiconductor layer comprises a semiconductor material or consists of a semiconductor material. Exemplarily, the semiconductor material is based on silicon. The first semiconductor layer comprises, for example, a first dopant of the first conductivity type.

According to the embodiment, the power semiconductor device comprises a drift layer of the first conductivity type. The drift layer extends exemplarily in lateral directions. For example, the drift layer comprises a semiconductor material or consists of a semiconductor material. Exemplarily, the semiconductor material comprises or consists of the same material than the first semiconductor layer. The drift layer comprises, for example, a further first dopant of the first conductivity type. The further first dopant of the drift layer is, for example, the same dopant than in the first semiconductor layer.

For example, a maximum doping concentration of the drift layer is lower than a maximum doping concentration of the first semiconductor layer. The maximum doping concentration of the drift layer is, for example, at least one order of magnitude smaller than the maximum doping concentration of the first semiconductor layer.

According to the embodiment, the power semiconductor device comprises a second semiconductor layer of a second conductivity type different from the first conductivity type. The second semiconductor layer extends exemplarily in lateral directions. For example, the second semiconductor layer comprises a semiconductor material or consists of a semiconductor material. Exemplarily, the semiconductor material comprises or consists of the same material than the first semiconductor layer. The first semiconductor layer comprises, for example, a second dopant of the second conductivity type.

Exemplarily, the first conductivity type is an n-conductivity type and the second conductivity type is a p-conductivity type or vice versa. For example, the first dopant is an n-type dopant and the second dopant is a p-type dopant or vice versa.

According to the embodiment, the power semiconductor device comprises a second electrode. The second electrode extends exemplarily in lateral directions. For example, the second electrode is configured to be electrically conductively contacted externally. Exemplarily, the second electrode comprises or consists of a metal.

The second electrode can comprise a third layer and a fourth layer, being stacked above one another in vertical direction. For example, the third layer comprises a metal which is different than a metal comprised by the fourth layer. The third layer comprises exemplarily aluminum and/or other metals like copper, titanium, nickel, tungsten, platinum and/or gold and the fourth layer comprises exemplarily molybdenum. In particular, the third layer is a metallization and the further layer is configured to be electrically conductively contacted externally.

For example, the first electrode is a cathode electrode of the power semiconductor device and the second electrode is an anode electrode of the power semiconductor device or vice versa.

The first layer and the fourth layer are, for example, not present in the power semiconductor device. The first layer and the fourth layer are, for example, provided in order to handle the power semiconductor device, wherein the first electrode solely comprises the second layer and the second electrode solely comprises the third layer.

According to the embodiment of the power semiconductor device, an oxide layer extending in an active region of the power semiconductor device being surrounded by a termination region of the power semiconductor device is arranged on at least one of the first semiconductor layer and the second semiconductor layer. The termination region is a peripheral region of the power semiconductor device and the active region is a central region of the power semiconductor device. This is the peripheral region completely surrounds the active region in lateral directions.

The active region is located at a center of mass of the power semiconductor device and extends in lateral directions in direction to at least one edge of the power semiconductor device. The termination region extends in lateral directions along an edge region of the power semiconductor device delimiting the active region.

For example, the oxide layer is arranged only on the first semiconductor layer or only on the second semiconductor layer. Alternatively, the oxide layer is arranged on both the first semiconductor layer and the second semiconductor layer.

The oxide layer extends within the active region, in particular from the termination region in direction to the center of mass. Exemplarily, the oxide layer has a shape in plan view which is circular, elliptical or polygonal, such as quadrangular. In particular, the shape in plan view of the oxide layer corresponds to an outer shape in plan view of the power semiconductor device, in particular the drift layer.

If the oxide layer is arranged on the first semiconductor layer, the oxide layer faces the first electrode. The oxide layer comprises the semiconductor material of the first semiconductor layer, which is in particular oxidized.

Exemplarily, the oxide layer is produced by a plasma-enhanced chemical vapor deposition (PECVD) process being regionally applied to the bottom surface of the first semiconductor layer. In particular, a material of the oxide layer is applied over the bottom surface of the first semiconductor layer, in particular completely. Subsequently, a photoresist is applied exemplarily over the bottom surface of the material of the oxide layer, in particular completely. The photoresist is, for example, structured, in particular with a mask, in order to produce the oxide layer.

For example, the oxide layer protrudes in vertical direction beyond the first semiconductor layer in direction to the first electrode.

If the oxide layer is arranged on the second semiconductor layer, the oxide layer faces the second electrode. The oxide layer comprises the semiconductor material of the second semiconductor layer, which is in particular oxidized.

Exemplarily, the oxide layer is produced by a plasma-enhanced chemical vapor deposition (PECVD) process being regionally applied to the top surface of the first semiconductor layer. In particular, a material of the oxide layer is applied over the top surface of the second semiconductor layer, in particular completely. Subsequently, a photoresist is applied exemplarily over the top surface of the material of the oxide layer, in particular completely. The photoresist is, for example, structured, in particular with a mask, in order to produce the oxide layer.

For example, the oxide layer protrudes in vertical direction beyond the second semiconductor layer in direction to the second electrode.

The oxide layer has a height in vertical direction of at most 1 pm.

For example, the power semiconductor described here is a fast recovery diode, in particular a free floating discrete fast recovery diode. Furthermore, the power semiconductor described here can be a reverse conducting integrated gate-commutated thyristor, RC-IGCT. An RC-IGCTS comprises a diode part and a GCT part, wherein a separation region is arranged between the diode part and a GCT part. The diode comprises all elements described herein of the active region and the separation region is formed of all elements of the termination region.

In summary, such a power semiconductor device having a combination of a first and/or second semiconductor layer and an oxide layer, can provide, inter alia, the following advantages.

Advantageously, the oxide layer reduce an emitter injection efficiency in the termination region. Due to the oxide region, the termination region of the power semiconductor device is effectively disconnected in an electrical manner from operation in the conduction (ON)-state by reducing significantly the emitter injection efficiency in the termination region. Advantageously, less heat is generated in the termination region with lower cooling capability. Thus, thermal stability is increased during frequency operation or in surge current event which enables the power semiconductor device to operate at higher Temperatures.

Due to the oxide layer in the active region, and particularly adjoining the termination region, the emitter injection efficiency can be reduced advantageously as well as predetermined in particular precisely.

According to a further embodiment of the power semiconductor device, the first electrode, the first semiconductor layer, the drift layer, the second semiconductor layer and the second electrode are stacked above one another along a stacking direction in vertical direction. Directly neighboring elements are, for example in direct contact to one another. Exemplarily, the first layer of the first electrode faces away from the first semiconductor layer and the second layer of the first electrode faces the first semiconductor layer. Exemplarily, the third layer of the second electrode faces the second semiconductor layer and the fourth layer of the second electrode faces away from the second semiconductor layer.

According to a further embodiment of the power semiconductor device, the first semiconductor layer comprises a first sublayer facing the first electrode and a second sublayer facing the drift layer. For example, a maximum doping concentration of the first sublayer is higher than a maximum doping concentration of the second sublayer. The maximum doping concentration of the first sublayer is, for example, at least one order of magnitude higher than the maximum doping concentration of the second sublayer.

According to a further embodiment of the power semiconductor device, the second semiconductor layer comprises a third sublayer facing the drift layer and a fourth sublayer facing the second electrode. For example, a maximum doping concentration of the fourth sublayer is higher than a maximum doping concentration of the third sublayer. The maximum doping concentration of the fourth sublayer is, for example, at least one order of magnitude higher than the maximum doping concentration of the third sublayer.

According to a further embodiment of the power semiconductor device, one of the first electrode and the second electrode extend over the active region and the termination region. In particular only one of the first electrode and the second electrode extend over the active region and the termination region.

For example, the first electrode extends completely over the first semiconductor layer in lateral directions. In particular, the second layer of the first electrode completely covers the bottom surface of the first sublayer of the first semiconductor layer, in particular in the active region and the termination region. Exemplarily, the first layer of the first electrode covers the second layer of the first electrode only in the active region. This is that the first layer of the first electrode extends only in the active region in lateral directions.

Alternatively, the second electrode extends completely over the second semiconductor layer in lateral directions. In particular, the third layer of the second electrode completely covers the top surface of the fourth sublayer of the second semiconductor layer, in particular in the active region and the termination region. Exemplarily, the fourth layer of the second electrode covers the third layer of the second electrode only in the active region. This is that the fourth layer of the second electrode extends only in the active region in lateral directions.

According to a further embodiment of the power semiconductor device, one other of the first electrode and the second electrode extends only over the active region.

If, the first electrode extends completely over the first semiconductor layer in lateral directions, i.e. over the active region and the termination region, the second electrode only extends over the active region. In particular, the third layer and the fourth layer of the second electrode have the same extent in lateral directions.

If, the second electrode extends completely over the second semiconductor layer in lateral directions, i.e. over the active region and the termination region, the first electrode only extends over the active region. In particular, the first layer and the second layer of the first electrode have the same extent in lateral directions.

According to a further embodiment of the power semiconductor device, the fourth sublayer extends in lateral directions over the active region and the termination region. For example, the fourth sublayer overlaps in plan view with the active region and at least regionally with the termination region. If the second semiconductor layer has the bevel structure, the fourth sublayer overlaps in plan view with the termination region to at least 20 % or at least 50 %.

According to a further embodiment of the power semiconductor device, the fourth sublayer extends only over the active region. In particular, the fourth sublayer overlaps in plan view only with the active region and not with the termination region.

This advantageously reduces the emitter efficiency in the termination region further.

According to the embodiment of the power semiconductor device, at least one of the first semiconductor layer and the second semiconductor layer has a bevel structure. Exemplarily, the first semiconductor layer and the second semiconductor layer each has a bottom surface and a top surface both extending in lateral directions, where the top surface and the bottom surface is connected with at least one side surface. The side surface of at least one of the first semiconductor layer and the second semiconductor layer is inclined to the vertical direction in the termination region.

For example, the bevel structure is arranged in the termination region. In particular, the bevel structure is solely arranged in the termination region. This is that the bevel structure defines an extent of the termination region in lateral directions.

According to a further embodiment of the power semiconductor device, the second semiconductor layer tapers towards the second electrode in the termination region. This is the bevel structure is arranged in the second semiconductor layer such that the side surface of the second semiconductor layer encloses an angle of less than 90° with the top surface of the drift layer.

Dependent on the angle, i.e. dependent on a steepness of the bevel structure, a junction depth can be predetermined. This is that dependent on the angle the emitter efficiency in the termination region can be preset in a precise manner.

According to a further embodiment of the power semiconductor device, the first semiconductor layer tapers towards the first electrode in the termination region. This is the bevel structure is arranged in the first semiconductor layer such that the side surface of the first semiconductor layer encloses an angle of less than 90° with the bottom surface of the drift layer.

Advantageously, dependent on the angle the emitter efficiency in the termination region can be preset particularly precisely.

According to a further embodiment of the power semiconductor device, the oxide layer is located on the first sublayer in the active region and in the termination region. Exemplarily, the bottom surface of the first sublayer and the bottom surface of the oxide layer are not in a common plane.

Exemplarily, the oxide layer extends only partially over the active region and completely over the termination region. If the bevel structure is arranged in the second semiconductor layer, the oxide layer completely covers the first electrode in the termination region.

Alternatively, if the bevel structure is arranged in the first semiconductor layer, the oxide layer completely covers the second electrode in the termination region.

According to a further embodiment of the power semiconductor device, the oxide layer is located between the first sublayer and the first electrode. Exemplarily, the bottom surface of the first sublayer and the bottom surface of the oxide layer are in direct contact to the first electrode, in particular the second layer.

According to a further embodiment of the power semiconductor device, the oxide layer extends in lateral directions from the termination region in the active region up to an extension distance. In particular, the oxide layer extends in lateral directions from the interface between the termination region and the active region up to an extension distance in the active region in lateral directions.

According to a further embodiment of the power semiconductor device, the extension distance is at least 1 and at most 7 times a height in vertical direction of the drift layer. In particular, the extension distance is at least 3 and at most 5 times the height of the drift layer.

With such an extension distance, the emitter efficiency is advantageously reduced at the interface between the termination region in the active region.

According to a further embodiment of the power semiconductor device, a further oxide layer is located on the fourth sublayer in the active region. Exemplarily, the top surface of the fourth sublayer and a top surface of the further oxide layer are not in a common plane.

If the bevel structure is arranged in the second semiconductor layer, the further oxide layer only covers the second electrode partially in the active region. The termination region is, for example, free of the further oxide layer.

Alternatively, if the bevel structure is arranged in the first semiconductor layer, the further oxide layer only covers the first electrode partially in the active region. The termination region is, for example, free of the further oxide layer.

According to a further embodiment of the power semiconductor device, the further oxide layer is located between the fourth sublayer and the second electrode. Exemplarily, the top surface of the fourth sublayer and the top surface of the oxide layer are in direct contact to the second electrode, in particular the third layer.

According to a further embodiment of the power semiconductor device, the further oxide layer extends in lateral directions from the termination region in the active region up to a further extension distance. In particular, the further oxide layer extends in lateral directions from the interface between the termination region and the active region up to the further extension distance in the active region in lateral directions.

According to a further embodiment of the power semiconductor device, the further extension distance is at least 1 and at most 7 times a height in vertical direction of the drift layer. In particular, the further extension distance is at least 3 and at most 5 times the height of the drift layer.

The further extension distance can be equal to the extension distance. Alternatively, the further extension distance is different to the extension distance.

According to a further embodiment, the power semiconductor device comprises a passivation. The passivation encapsulates the layers of the power semiconductor device, for example. The first electrode and the second electrode are, in particular, partially free of the passivation. Exemplarily, the first layer of the first electrode and the fourth layer of the second electrode are free of the passivation.

The passivation comprises an electrically insulating material, such as a dielectric material. For example, the passivation material comprises a semi-insulating material at silicon surface. Beside the insulation of semiconductor surface from surroundings, the role of such material is the drainage of leakage current to one of electrodes, especially at elevated temperatures.

According to a further embodiment of the power semiconductor device, the first electrode, the first semiconductor layer, the drift layer, the second semiconductor layer and the second electrode are surrounded by the passivation in the termination region. For example, side surfaces of the layers and the electrodes are completely covered by the passivation.

Exemplarily, the bevel structure is completely embedded in the passivation. This is that the side surface, which forms the bevel structure, is completely covered with the passivation.

Advantageously, the power semiconductor device is protected from an environment due to the passivation.

According to a further embodiment of the power semiconductor device, the first semiconductor layer is structured by several doped regions of the second conductivity type in the termination region.

The doped regions extend within the termination region. Exemplarily, the doped regions each have a shape in plan view which is circular, elliptical or polygonal, such as quadrangular. In particular, the shape in plan view of the doped regions corresponds to the outer shape in plan view of the power semiconductor device, in particular the drift layer.

For example, the doped regions are arranged in the semiconductor layer, on which the oxide layer is not arranged. If the first semiconductor layer comprises the doped regions, the oxide layer is arranged on the second semiconductor layer. If the second semiconductor layer comprises the doped regions, the oxide layer is arranged on the first semiconductor layer.

Exemplarily, the first sublayer comprises the doped regions and/or the fourth sublayer comprises the doped regions.

According to a further embodiment of the power semiconductor device, the first sublayer is separated into segments in lateral directions by the doped regions. Exemplarily, the segments are spaced apart by the doped regions in lateral directions. This is that directly neighboring segments are in particular not in physical contact to one another.

With the doped regions, in particular a combination of the oxide layer and the doped regions, the emitter efficiency can be predetermined and reduced in particular precisely.

Furthermore, a method for producing a power semiconductor device is described here, with which a power semiconductor device as described herein above can be produced or is produced. Therefore, the features in connection with the power semiconductor device are disclosed also in connection with the method and vice versa.

According to an embodiment of the method, a semiconductor material is provided with a drift layer. Exemplarily, the semiconductor material is based on silicon. The semiconductor material is provided, in particular, as a wafer.

Exemplarily, the drift layer of a first conductivity type is produced during silicon ingot pulling. In other words, it is present in the starting silicon wafer prior to production.

According to the embodiment of the method, a first semiconductor layer of the first conductivity type is produced in the drift layer from a first side. Exemplarily, the first dopant is incorporated in the wafer, e.g. the drift layer from the first side, e.g. by at least one of an ion implantation or a deposition process, which may be followed by a diffusion process.

According to the embodiment of the method, a second semiconductor layer of a second conductivity type different of the first conductivity type is produced in the drift layer from a second side opposite the first side. Exemplarily, the second dopant is incorporated in the wafer, e.g. the drift layer from the second side, e.g. by at least one of an ion implantation or a deposition process, which may be followed by a diffusion process.

According to the embodiment of the method, a bevel structure is produced in at least one of the first semiconductor layer and the second semiconductor layer in a termination region surrounding an active region of the power semiconductor device.

According to the embodiment of the method, an oxide layer is produced on at least one of the first semiconductor layer or the second semiconductor layer.

According to a further embodiment of the method, the bevel structure is produced by a grinding process.

The accompanying Figures are included to provide a further understanding. In the Figures, elements of the same structure and/or functionality may be referenced by the same reference signs. It is to be understood that the embodiments shown in the Figures are illustrative representations and are not necessarily drawn to scale.

Figures 1 to 3 each is a cross sectional view of a power semiconductor device according to an exemplary embodiment, Figure 4 is a schematic plan view of a power semiconductor device according to an exemplary embodiment, and

Figure 5 is an exemplary diagram of a hole density for different exemplary embodiments of a power semiconductor device.

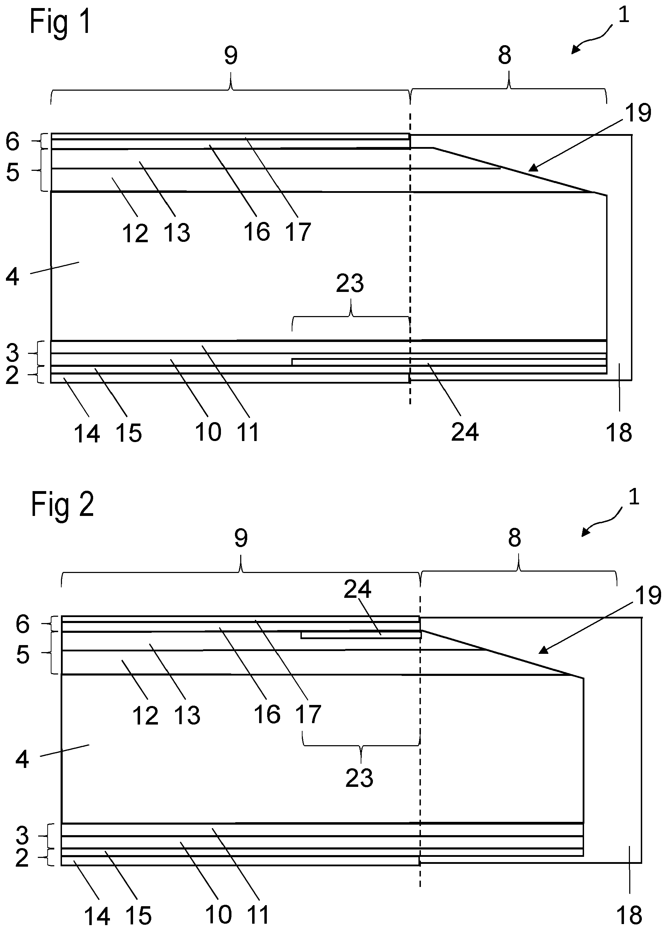

The power semiconductor device 1 according to the exemplary embodiment of Figure 1 comprises a first electrode 2 comprising a first layer 14 and a second layer 15 as well as a second electrode 6 comprising a third layer 16 and a fourth layer 17. The power semiconductor device 1 further comprises a first semiconductor layer 3 of a first conductivity type comprising a first sublayer 10 and a second sublayer 11 as well as a second semiconductor layer 5 of a second conductivity type comprising a third sublayer 12 and a fourth sublayer 13. Further, the power semiconductor device 1 comprises a drift layer 4.

The first electrode 2, in particular the first layer 14 and the second layer 15, the first semiconductor layer 3, in particular the first sublayer 10 and the second sublayer 11, the drift layer 4, the second semiconductor layer 5, in particular the third sublayer 12 and the fourth sublayer 13 and the second electrode 6, in particular the third layer 16 and the fourth layer 17, are stacked above one another in a stacking direction corresponding to a vertical direction. Each of the layers extend in lateral directions being perpendicular to the vertical direction. Further, each of the layers are in direct contact to one another. Bottom surfaces of the layers face the first electrode 2 and top surfaces of the layers face the second electrode 6.

The second layer 15 of the first electrode 2 completely covers a bottom surface of the first sublayer 10 of the first semiconductor layer 3. The first layer 14 of the first electrode 2 completely covers a bottom surface of the second layer 15 only in an active region 9 of the power semiconductor device 1. This is that the first layer 14 completely overlaps with the active region 9 in lateral directions in plan view, in particular congruently.

In particular, the plan view is a view in vertical direction on the top surfaces of the elements of the power semiconductor device 1.

The active region 9 is located at and extends in lateral directions around a center of mass of the power semiconductor device 1. Figure 1 shows only one half of the power semiconductor device 1. Exemplarily, the left edge in Figure 1 comprises the center of mass.

A termination region 8 extends in lateral directions along an edge region of the power semiconductor device 1 delimiting the active region 9. The termination region 8 is free of the first layer 14 of the first electrode 2. This is that the first layer 14 does not overlap with the termination region 8 in lateral directions in plan view.

The third layer 16 of the second electrode 6 completely covers a top surface of the fourth sublayer 13 of the second semiconductor layer 5 only in the active region 9. The fourth layer 17 of the second electrode 6 completely covers a top surface of the third layer 16. This is that the third layer 16 and the fourth layer 17 each completely overlaps with the active region 9 in lateral directions in plan view, in particular congruently.

The termination region 8 is free of the third layer 16 and the fourth layer 17 of the second electrode 6. This is that the third layer 16 and the fourth layer 17 each do not overlap with the termination region 8 in lateral directions in plan view.

The second semiconductor layer 5 has a bevel structure 19 in the termination region 8. A side surface of the second semiconductor layer 5, connecting the top surface and the bottom surface of the second semiconductor layer 5, is inclined to the vertical direction. The side surface of the second semiconductor layer 5 is only inclined in the termination region 8. An angle between the side surface of the second semiconductor layer 5 and the bottom surface of the second semiconductor layer 5 is smaller than 90°, in particular smaller than 45°. This is that the third sublayer 12 and the fourth sublayer 13 taper towards the second electrode 6 in the termination region 8.

The oxide layer 24 extending in the active region 9 and in the termination region 8 is arranged on the first sublayer 10 of the first semiconductor layer 3. The oxide layer 24 faces the first electrode 2. The oxide layer 24 comprises the semiconductor material of the first semiconductor layer 3.

The bottom surface of the oxide layer 24 protrudes beyond the bottom surface of the first sublayer 10 in vertical direction to the first electrode 2. The first electrode 2 completely covers the bottom surface of the first sublayer 10 and the bottom surface of the oxide layer 24.

The oxide layer 24 extends only partially over the active region 9 and completely over the termination region 8. This is that the oxide layer 24 completely overlaps with the termination region 8 in plan view. The oxide layer 24 extends in lateral directions from an interface of the active region 9 and the termination region 8 in the active region 9 up to an extension distance 23. The extension distance 23 is at least 1 and at most 7 times a height in vertical direction of the drift layer 4.

The power semiconductor device 1 further comprises a passivation 18. The passivation 18 encapsulates the layers of the power semiconductor device 1, wherein the first electrode 2 and the second electrode 6 are, in particular, partially free of the passivation 18.

The fourth sublayer 13 of the second semiconductor layer 5 according to the exemplary embodiment of Figure 2 comprises the oxide layer 24 in contrast to the exemplary embodiment of Figure 1. The oxide layer 24 extends only in the active region 9. This is that the oxide layer 24 completely overlaps with the active region 9 in the extension distance 23 in plan view and further, the oxide layer 24 does not overlap with the termination region 8 in plan view.

The oxide layer 24 faces the second electrode 6. The oxide layer 24 comprises the semiconductor material of the second semiconductor layer 5.

The top surface of the oxide layer 24 protrudes beyond the top surface of the fourth sublayer 13 in vertical direction to the second electrode 6. The second electrode 6 completely covers the top surface of the fourth sublayer 13 and the top surface of the oxide layer 24.

As in Figure 1, the oxide layer 24 extends in lateral directions from the interface of the active region 9 and the termination region 8 in the active region 9 up to the extension distance 23.

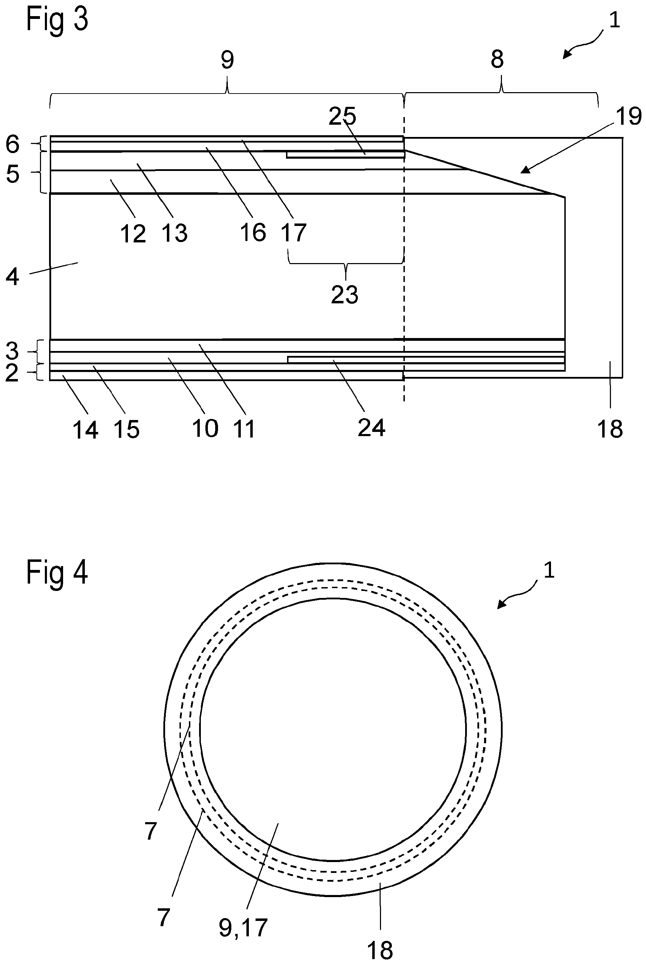

The power semiconductor device 1 according to the exemplary embodiment of Figure 4 has an oxide layer 24 and a further oxide layer 25. The oxide layer 24 on the first sublayer 10 corresponds to the oxide layer 24 in Figure 1 and the further oxide layer 25 on the fourth sublayer 13 corresponds to the oxide layer 24 in Figure 2.

The power semiconductor device 1 according to the exemplary embodiment of Figure 4 is a plan view of one of the power semiconductor devices 1 according to one of the Figures 1 to 3. In plan view, the top surface of the fourth layer 17 and the passivation 18 is freely accessible. An outer shape of the power semiconductor device 1 is circular.

The doped regions are not visible in this view such that they are indicated as dashed lines. The doped regions extend within the termination region 8, wherein each of the doped regions completely surround the active region 9 in lateral directions. In particular each of the doped regions has a circular shape in plan view corresponding to an outer shape in plan view of the power semiconductor device 1.

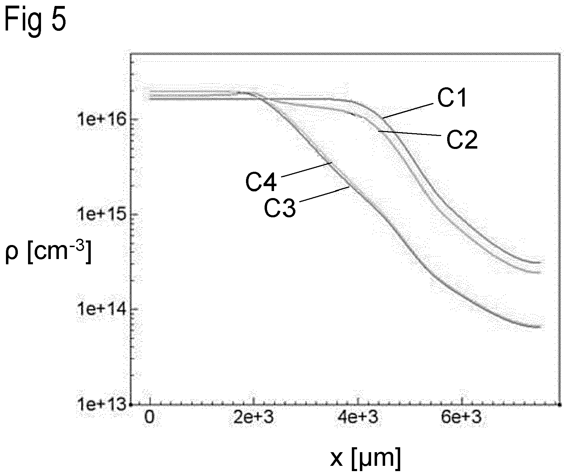

In the diagram according to Figure 5, the y axis is characteristic for a hole density ρ in cm⁻³ and the x axis is characteristic for a distance x in pm from the center to the edge region of the power semiconductor device 1 in lateral directions in the drift layer 4.

Curve C1 corresponds to a typical power semiconductor device 1 without a first semiconductor layer 3 with an oxide layer 24. Curve C2 corresponds to a power semiconductor device 1 according to Figure 1, curve C3 corresponds to a power semiconductor device 1 according to Figure 2 and curve C4 corresponds to a power semiconductor device 1 according to Figure 3.

### Reference Signs

- 1: power semiconductor device
- 2: first electrode
- 3: first semiconductor layer
- 4: drift layer
- 5: second semiconductor layer
- 6: second electrode
- 7: doped regions
- 8: termination region
- 9: active region
- 10: first sublayer
- 11: second sublayer
- 12: third sublayer
- 13: fourth sublayer
- 14: first layer
- 15: second layer
- 16: third layer
- 17: fourth layer
- 18: passivation
- 19: bevel structure
- 20: segments
- 21: further doped region
- 23: extension distance
- 24: oxide layer
- 25: further oxide layer

## Claims

1. Power semiconductor device (1), comprising
- a first electrode (2),
- a first semiconductor layer (3) of a first conductivity type,
- a drift layer (4) of the first conductivity type,
- a second semiconductor layer (5) of a second conductivity type different from the first conductivity type, and
- a second electrode (6), wherein
- an oxide layer (24) extending in an active region (9) of the power semiconductor device (1) being surrounded by a termination region (8) of the power semiconductor device (1) is arranged on at least one of the first semiconductor layer (3) and the second semiconductor layer (5).

2. Power semiconductor device (1) according to claim 1, wherein
- the first electrode (2), the first semiconductor layer (3), the drift layer (4), the second semiconductor layer (5) and the second electrode (6) are stacked above one another along a stacking direction in vertical direction.

3. Power semiconductor device (1) according to one of the claims 1 or 2, wherein
- the first semiconductor layer (3) comprises a first sublayer (10) facing the first electrode (2) and a second sublayer (11) facing the drift layer (4), and
- the second semiconductor layer (5) comprises a third sublayer (12) facing the drift layer (4) and a fourth sublayer (13) facing the second electrode (6).

4. Power semiconductor device (1) according to claim 1 to 3, wherein
- one of the first electrode (2) and the second electrode (6) extends over the active region (9) and the termination region (8), and
- one other of the first electrode (2) and the second electrode (6) extends only over the active region (9).

5. Power semiconductor device (1) according to one of the claims 3 or 4, wherein
- the fourth sublayer (13) extends in lateral regions over the active region (9) and the termination region (8), or
- the fourth sublayer (13) extends only over the active region (9).

6. Power semiconductor device (1) according to one of the claims 1 to 5, wherein
- at least one of the first semiconductor layer (3) and the second semiconductor layer (5) has a bevel structure (19), and at least one of
- the second semiconductor layer (5) tapers towards the second electrode (6) in the termination region (8), and
- the first semiconductor layer (3) tapers towards the first electrode (2) in the termination region (8).

7. Power semiconductor device (1) according to one of the claims 3 to 6, wherein
- the oxide layer (24) is located on the first sublayer (10) in the active region (9) and in the termination region (8), and
- the oxide layer (24) is located between the first sublayer (10) and the first electrode (2).

8. Power semiconductor device (1) according to one of the claims 1 to 7, wherein
- the oxide layer (24) extends in lateral directions from the termination region (8) in the active region (9) up to an extension distance (23), and
- the extension distance (23) is at least 1 and at most 7 times a height in vertical direction of the drift layer (4).

9. Power semiconductor device (1) according to one of the claims 3 to 8, wherein
- a further oxide layer (25) is located on the fourth sublayer (13) in the active region (9), and
- the further oxide is layer located between the fourth sublayer (13) and the second electrode (6).

10. Power semiconductor device (1) according to claim 9, wherein
- the further oxide layer (25) extends in lateral directions from the termination region (8) in the active region (9) up to a further extension distance (23), and
- the further extension distance (23) is at least 1 and at most 7 times a height in vertical direction of the drift layer (4).

11. Power semiconductor device (1) according to one of the claims 1 to 10, wherein
- the first semiconductor layer (3) is structured by several doped regions (7) of the second conductivity type in the termination region (8).

12. Power semiconductor device (1) according to claim 11, wherein
- the first sublayer (10) is separated into segments (20) in lateral directions by the doped regions (7).

13. Power semiconductor device (1) according to one of the claims 1 to 12, further comprises
- a passivation (18), wherein
- the first electrode (2), the first semiconductor layer (3), the drift layer (4), the second semiconductor layer (5) and the second electrode (6) are surrounded by the passivation (18) .

14. Method for producing a semiconductor device, comprising
- providing a semiconductor material with a drift layer (4) of a first conductivity type,
- producing a first semiconductor layer (3) of the first conductivity type in the drift layer (4) from a first side,
- producing a second semiconductor layer (5) of a second conductivity type different of the first conductivity type in the drift layer (4) from a second side opposite the first side,
- producing a bevel structure (19) in at least the first semiconductor layer (3) and the second semiconductor layer (5) in a termination region (8) surrounding an active region (9) of the power semiconductor device (1), and
- producing an oxide layer (24) on at least one of the first semiconductor layer (3) or the second semiconductor layer (5) .

15. Method according to claim 14, wherein at least one of
- the bevel structure (19) is produced by a grinding process.
